Europäisches Patentamt

European Patent Office

Office européen des brevets

(11) Numéro de publication: **0 228 741 B1**

# (12) FASCICULE DE BREVET EUROPEEN

(45) Date de publication de fascicule du brevet:
26.06.91

(51) Int. Cl.⁵: **G01R 1/073**

(21) Numéro de dépôt: 86202256.3

(22) Date de dépôt: 16.12.86

(54) Dispositif de test pour boîtier sans broches muni d'une pastille de circuit intégré hyperfréquences.

(30) Priorité: 20.12.85 FR 8518925

(43) Date de publication de la demande:
15.07.87 Bulletin 87/29

(45) Mention de la délivrance du brevet:
26.06.91 Bulletin 91/26

(84) Etats contractants désignés:
DE FR GB IT

(56) Documents cités:
US-A- 3 496 464
US-A- 4 161 692
US-A- 4 554 505

IEEE SEMICONDUCTOR TEST SYMPOSIUM,
Cherry Hill, N.J., 5 - 7 novembre 1974, pages
171-176, IEEE Computer Society, Long
Beach, US; B.H. McGAHEY: "Test probe for
high speed functional testing of silicon IC's"

(73) Titulaire: **LABORATOIRES D'ELECTRONIQUE PHILIPS**
**3, Avenue Descartes**
**F-94450 Limeil-Brévannes(FR)FR**

Titulaire: **N.V. Philips' Gloeilampenfabrieken**
**Groenewoudseweg 1**
**NL-5621 BA Eindhoven(NL)DE GB IT**

(72) Inventeur: **Binet, Michel Joseph Marie**
**Société Civile SPID 209, rue de l'Université**
**F-75007 Paris(FR)**
Inventeur: **Meignant, Didier Serge**
**Société Civile SPID 209, rue de l'Université**
**F-75007 Paris(FR)**

(74) Mandataire: **Landousy, Christian et al**
**Société Civile S.P.I.D. 156, Boulevard Haussmann**
**F-75008 Paris(FR)**

# Description

L'invention concerne un dispositif de test pour boîtier sans broches, destiné à permette le transport des signaux des n plots d'entrées/sorties de ce boîtier vers des appareils de mesure au moyen de lignes hyperfréquences d'impédance caractéristique donnée, dans le cas où ce boîtier est muni d'une pastille de circuit intégré hyperfréquences.

L'invention trouve son application dans le domaine de fabrication des circuits intégrés hyperfréquences.

Par boîtier sans broches, il faut entendre des boîtiers spéciaux, plus connus de l'homme du métier sous le nom anglo-saxon de "CHIP-CARRIER". Ces boîtiers possèdent la propriété de pouvoir être soudés directement à un circuit imprimé périphérique, par montage en surface. Ceci permet de s'affranchir des liaisons par fils qui sont incompatibles avec les technologies hyperfréquences. D'autre part, ces boîtiers offrent une bonne protection pour les pastilles de circuit intégré, tout en maintenant un excellent niveau de qualité de ces circuits dans le cas où ils fonctionnent dans le domaine des hyperfréquences.

Cependant, avant le montage sur un circuit imprimé, le boîtier sans broches, muni de la pastille de circuit intégré, doit être testé.

Or, cette opération est particulièrement difficile à réaliser du fait de l'absence de broches. Cette opération est encore compliquée dans le cas de circuits hyperfréquences du fait que les signaux doivent impérativement être transportés par des lignes hyperfréquences d'impédance caractéristique donnée.

D'autre part, la demande des utilisateurs est, à ce jour, pour la fourniture d'un dispositif de test adapté à chaque circuit spécifique, en même temps que ledit circuit. Ainsi, les fournisseurs de circuits intégrés doivent-ils présenter en catalogue ce genre de dispositif de test, et les concepteurs de circuits doivent-ils prévoir des dispositifs de test commercialisables, donc de type grand public, simples et bon marché, en même temps que les circuits.

Un dispositif de test pour boîtier sans broches est connu du brevet US-A-4 554 505. Ce dispositif comprend un support inférieur, une plaque, pour le centrage du boîtier sans broche, munie d'une ouverture aux dimensions externes de ce boîtier, une plaque formée de lignes du type dit triplaque parallèles adjacentes disposées dans des directions parallèles aux plots du boîtier, et des moyens pour exercer une pression sur le boîtier sans broches afin de réaliser le contact entre ses plots périphériques et les extrémités des lignes triplaques les plus proches.

D'une part, comme il est explicité plus loin, l'emploi de lignes triplaques est un inconvénient pour la réalisation de contacts, dans le domaine des hyperfréquences faisant intervenir une pression. D'autre part, ce dispositif connu muni de ces lignes parallèles seulement distantes d'une valeur égale à la propre distance entre plots du boîtier sans broches, ne concerne pas le raccord à des lignes standards hyperfréquences pour la connexion à des appareils périphériques de test.

Un autre dispositif de test pour pastille de circuit intégré est connu par le brevet JP-55 72 876(A) (FUJITSU K.K). Ce dispositif connu comprend deux parties. La première partie est constituée d'une plaque épaisse en un matériau élastique sur laquelle est imprimé un circuit de conducteurs simples dont la géométrie permet de relier des plots très serrés, images des plots d'entrées/sorties de la pastille de circuit intégré à des plots conducteurs de grande surface, répartis à la périphérie de cette plaque élastique. La seconde partie est constituée d'un socle rigide, muni en sa partie centrale d'un trou de guidage destiné à recevoir la pastille de circuit intégré, ce trou ayant une profondeur inférieure à l'épaisseur de la pastille. Ce socle est en outre muni de terminaisons de conducteurs dont la répartition géométrique coïncide avec celle des plots conducteurs de grande surface placés en périphérie de la plaque élastique.

La mise en place de la pastille, circuit tourné vers l'extérieur, dans le trou de guidage du socle, et la pression de la plaque élastique, face conductrice vers le circuit, sur l'ensemble socle-pastille, permet de réaliser le contact entre les plots d'entrées/sorties de la pastille de circuit intégré et les terminaisons des conducteurs fixées dans le socle rigide.

Le problème résolu par le dispositif décrit dans le second document cité consiste donc à raccorder une pastille de circuit intégré directement par un circuit ordinaire à des appareils de mesure pour effectuer le test du circuit.

Mais le domaine d'application n'est pas celui des hyperfréquences. Ainsi les conducteurs de raccordement qui sont imprimés sur la plaque épaisse élastique sont d'abord du type simple conducteur, et ensuite de grande longueur, ce qui est incompatible avec le transport de signaux hyperfréquences. Cette plaque, en dehors de ses propriétés élastiques, ne possède pas de propriétés diélectriques particulières. D'autre part, les conducteurs dont l'extrémité apparaît dans le socle rigide, ne sont pas des lignes hyperfréquences. Aucun élément décrit dans ce document n'enseigne une possibilité de variante qui permettrait la transposition au domaine des hyperfréquences, alors que l'utilisation pure et simple d'un tel dispositif est absolument impossible dans ce domaine d'application.

D'autre part, le problème résolu par le dispositif décrit dans le second document cité ne concerne pas une pastille de circuit intégré déjà montée dans un boîtier sans broches.

C'est pourquoi la présente invention propose un dispositif de test qui, d'une part accepte une pastille de circuit intégré munie d'un boîtier sans broches, et d'autre part permet le transport des signaux hyperfréquences.

Selon la présente invention, ces problèmes sont résolus au moyen d'un dispositif tel que décrit dans le préambule et en outre caractérisé en ce qu'il comprend d'abord une plaque rigide, en un matériau présentant de bonnes qualités diélectriques en hyperfréquences, munie sur une face dite face avant d'un circuit imprimé formant un réseau de n lignes hyperfréquences en technologie coplanaire, de l'impédance caractéristique donnée, divergentes de la région de la plaque où est disposé le boîtier sans broches vers la périphérie de cette plaque, et en ce qu'il comprend en outre des premiers moyens pour connecter les n plots du boîtier aux n entrées des lignes du réseau coplanaire, et des seconds moyens pour connecter les n sorties des lignes du réseau coplanaire aux lignes hyperfréquences coaxiales de même impédance donnée qui alimentent les appareils de mesure.

Le dispositif conforme à l'invention fournit donc une solution aux problèmes précédemment cités. Il fournit en outre des avantages tels que entre autres :

- une mise en oeuvre des tests qui est simple et qui ne viendra pas grever le coût des circuits hyperfréquences, actuellement encore assez élevé du fait de leur nouveauté et de difficultés annexes non encore résolues ;
- la possibilité d'être présenté sur catalogue en même temps que le circuit, comme un composant grand public ;
- de bons contacts électriques sur chacune des aires de test ;
- une bonne continuité d'impédance en hyperfréquences. Cette bonne continuité d'impédance est subordonnée au fait que le couplage entre les lignes hyperfréquences conçues dans le dispositif selon l'invention pour raccorder les entrées/sorties du boîtier sans broches aux dispositifs de mesure périphériques, dépend de la pression entre la masse du dispositif et les plans de masse desdites lignes hyperfréquences : si la pression est inadaptée, alors le couplage entre ces lignes est trop fort et les mesures sont faussées ;
- une bonne reproductibilité des mesures.

L'invention sera mieux comprise à l'aide de la description suivante illustrée par les figures annexées dont :
- la figure 1 qui représente un exemple de boîtier sans broches, la figure 1a étant une vue d'une face, la figure 1b étant une vue en coupe, et la figure 1c une vue de l'autre face ;
- la figure 2 qui représente en coupe le premier sous-ensemble composant le dispositif de test ;
- la figure 3 qui représente un exemple de réalisation d'un réseau de lignes hyperfréquences coplanaires formé sur la plaque rigide ;
- la figure 4 qui représente un exemple de réalisation de connexions ultra-courtes formées sur une feuille mince et souple pour raccorder le boîtier aux lignes hyperfréquences coplanaires ;
- la figure 5 qui représente en coupe l'assemblage des différentes parties du dispositif de test selon l'invention ;
- la figure 6 qui montre en coupe le placement respectif d'une ligne coaxiale et de la plaque rigide dans le corps du dispositif.

La figure 1a représente donc la face 21 d'un boîtier 1 sans broches, qui dans cet exemple de réalisation est muni de 24 plots 4 d'entrées/sorties, ainsi que d'un plot supplémentaire 5 éventuellement pour le raccordement à la masse. Ce boîtier est formé d'un support isolant 2, qui pour les applications hyperfréquences peut être en céramique.

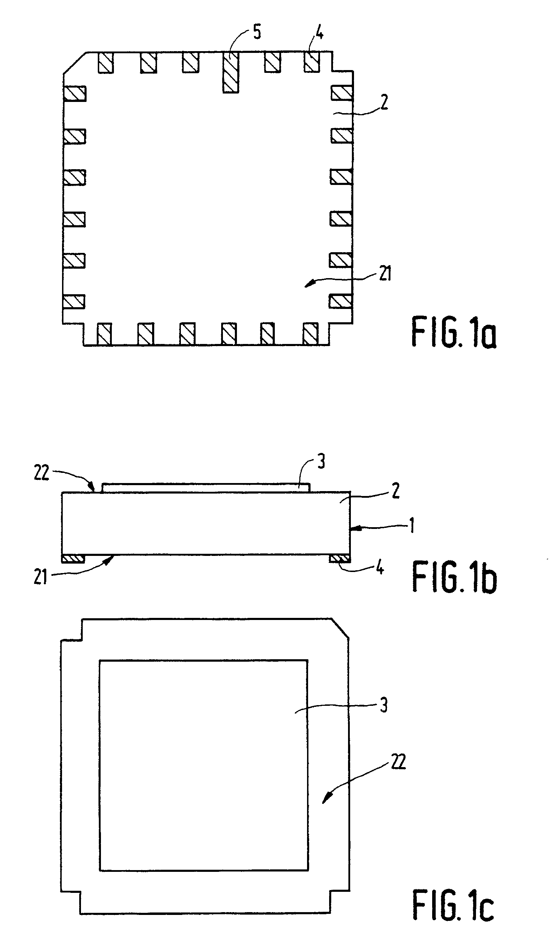

La coupe du boîtier représentée sur la figure 1b montre que les plots 4 (ou 5) apparaissent essentiellement sur la face 21 dite face avant du boîtier, et que la face 22 ou face arrière (représentée figure 1c) est munie d'un capot 3 qui protège un circuit intégré, non visible sur les figures, connecté aux plots 4 (ou 5).

L'état de la technique du boîtier sans broches est bien connu de l'homme du métier, et à ce sujet, on pourra se référer avec profit à l'article de C. VAL et alii, intitulé "Le Chip-Carrier, support universel de pastilles à haut niveau d'intégration" publié dans le journal "L'Electronique Industrielle" N° 31 -1-4-82.

Ce boîtier sans broches est, pour l'application envisagée dans le cadre de la présente invention, destiné à recevoir une pastille de circuit intégré hyperfréquences.

Dans le but de tester ce circuit hyperfréquences, les entrées/sorties du boîtier sans broches doivent être reliées à des appareils de mesures au moyen de lignes hyperfréquences d'impédance caractéristique donnée, par exemple 50 Ω.

Comme des lignes hyperfréquences coaxiales classiques ne peuvent être reliées directement au boîtier sans broches, la présente invention propose un dispositif intermédiaire qui permet la connexion entre les entrées/sorties du boîtier sans broches et les lignes hyperfréquences coaxiales classiques transportant les signaux aux appareils de mesure.

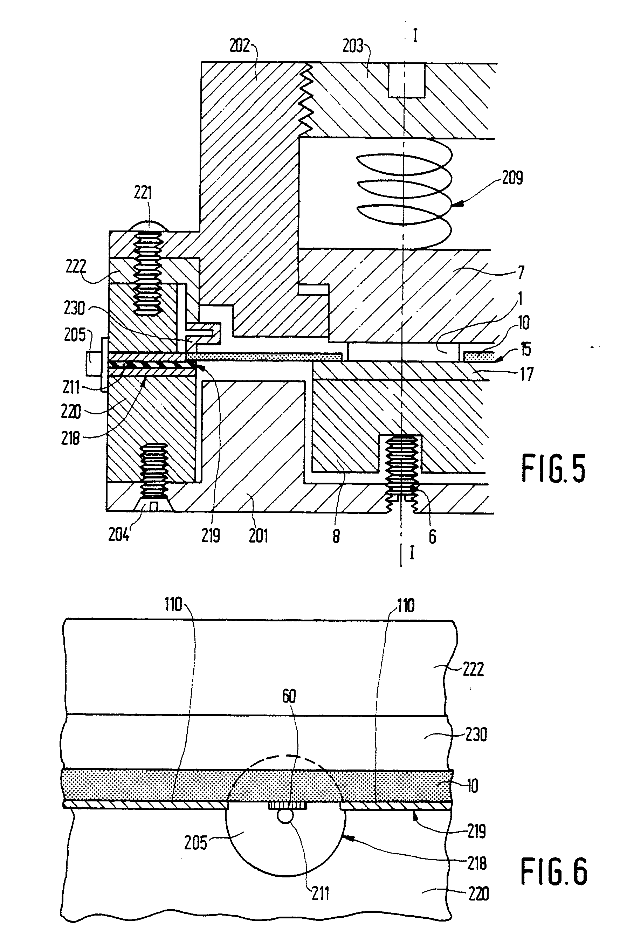

L'ensemble du dispositif de test selon l'invention est représenté en coupe sur la figure 5.

Cet ensemble comprend tout d'abord une plaque 10, réalisée en un matériau qui doit présenter à la fois des propriétés de rigidité, et des propriétés diélectriques appropriées à recevoir un circuit imprimé hyperfréquences 30. D'une façon avantageuse, ce matériau pourra être par exemple de la céramique.

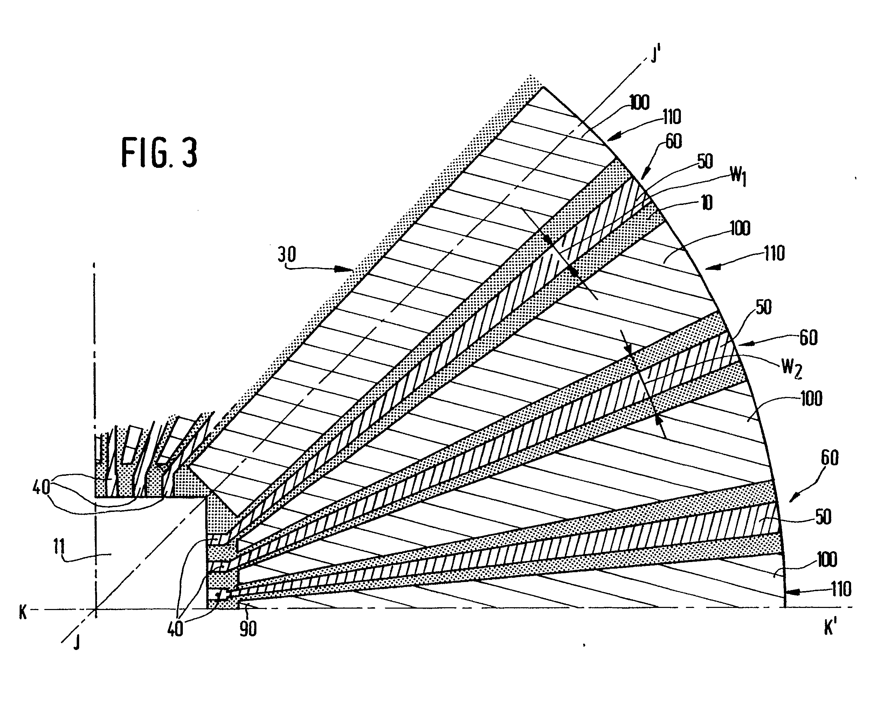

Cette plaque rigide 10 est percée d'une ouverture 11 qui la traverse de part en part, et qui est de dimensions et de forme aptes à laisser le passage sans frottements au boîtier 1. Cette plaque 10 est en outre munie du circuit imprimé 30 de lignes coplanaires, dont un exemple de réalisation est montré sur la figure 3.

Par ligne coplanaire, il faut entendre une ligne en forme de ruban métallisé 50 de largeur $W_1$ compris entre deux grandes aires métallisées 100 constituant la masse. Le ruban métallisé 50 constitue le conducteur central de la ligne hyperfréquences, les aires de masses étant séparées l'une de l'autre d'une distance $w_2$. Le ruban formant le conducteur central et les aires de masse sont réalisés sur la même face 12 de la plaque rigide 10.

L'intérêt de cette forme de réalisation de lignes hyperfréquences est très grand.

Cette technologie se différentie des autres technologies hyperfréquences comme par exemple les technologies triplaques ou bifilaires dans lesquelles les conducteurs et la masse sont réalisés de part et d'autre d'une plaque diélectrique. Ainsi, en technologie coplanaire, l'impédance caractéristique d'une ligne hyperfréquences ne dépend que du rapport $W_1/W_2$, et non comme dans les autres technologies citées, du rapport $W/e$, où W est la largeur du ruban formant le conducteur central et e est l'épaisseur de la plaque diélectrique.

Il est alors aisé, dans la technologie des lignes coplanaires, de réaliser des lignes d'impédance courante, comme 50 Ω par exemple, même avec des lignes étroites. On peut donc, à l'aide de cette technologie faire arriver un grand nombre de lignes d'impédance voulue, telle que 50 Ω, à proximité immédiate de l'ouverture 11 destinée au passage du boîtier 1.

On prévoira un nombre de lignes 50 égal au nombre des entrées/sorties 4 du boîtier 1, et les extrémités 40 de ces lignes seront de préférence dans le prolongement géométrique de ces plots 4 lorsque le boîtier est en place dans son logement 11. Dans l'exemple des figures 1 et 3, le boîtier 1 est muni de 24 plots d'entrées/sorties 4. Il a donc été prévu sur la plaque 10 également 24 lignes 50. Cependant la figure 3 ne représente qu'un huitième du circuit dont les autres parties s'obtiennent par symétrie autour de l'axe JJ' ou KK'.

Parmi les plots d'entrées/sorties du boîtier, en général un plot spécial 5 est réservé à la masse et l'on prévoira donc l'extrémité d'une aire de masse en regard de ce plot 5.

Mais cette répartition ne constitue qu'un exemple de réalisation. Dans un autre exemple de répartition des rubans 50 et des aires de masse 100, chaque plot du boîtier pourrait se trouver en regard soit d'un conducteur central, soit d'une aire de masse, et ainsi un plot sur deux du boîtier serait consacré à la masse.

De nombreuses configurations du circuit coplanaire 30 réalisé sur la face 12 dite face avant de la plaque rigide 10 sont donc possibles pour se mettre en accord avec les dimensions du boîtier 1 et le nombre des entrées /sorties.

De plus la plaque 10 pourra être aussi bien carrée que circulaire. D'une façon pratique, l'homme du métier adoptera facilement la forme carrée lorsque la plaque 10 comporte un nombre de lignes inférieur à 10, et la forme circulaire lorsque le nombre excède 10. Mais cette limite n'a aucun caractère impératif et le choix est purement laissé à l'utilisateur.

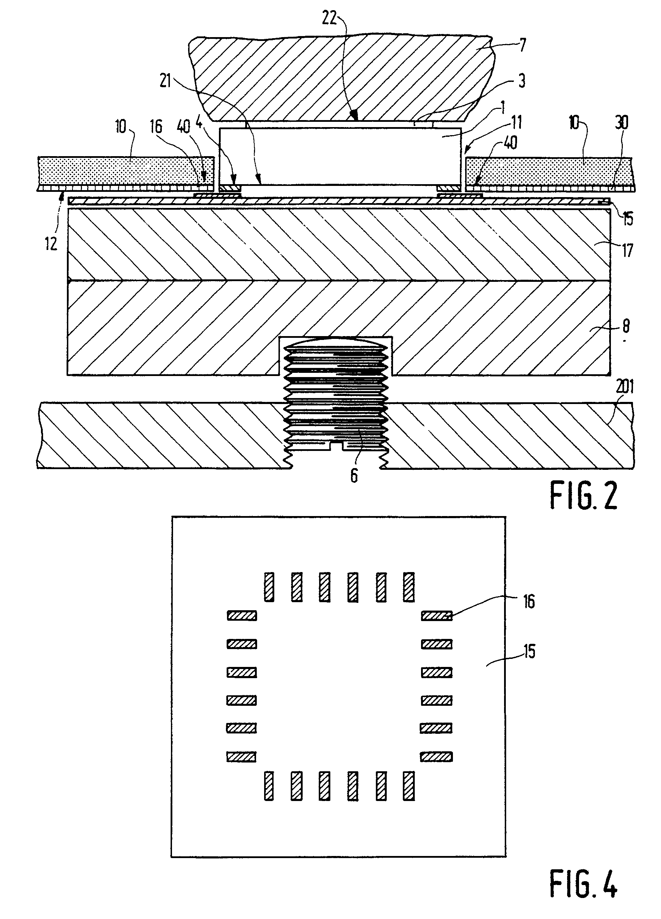

Le dispositif de test, représenté figure 5, comprend ensuite un premier sous-ensemble, représenté figure 2, destiné à assurer le raccordement des extrémités 40 et 90 dites entrées des lignes et aires de masse du circuit coplanaire 30 (figure 3) aux plots 4 (ou 5) d'entrées/sorties du boîtier 1.

A cet effet, le premier sous-ensemble est constitué d'abord, représenté figure 4, d'un circuit imprimé 16 de conducteurs extrêmement courts réalisé sur la face dite avant d'une feuille souple 15 d'un bon diélectrique, par exemple du KAPTON (marque déposée) ou du MYLAR (marque déposée) ou tout autre diélectrique, pourvu qu'il présente une faible épaisseur et une faible permittivité. Ces conducteurs extrêmement courts 16 sont destinés à réaliser la connexion entre les plots 4 ou 5 du boîtier et les extrémités 40 ou 90 des lignes coplanaires.

Pour obtenir un bon contact électrique et une bonne continuité d'impédance, la face avant de la feuille 15 est plaquée contre la face avant de la plaque rigide 10 et contre les plots 4 (ou 5) du boîtier, circuit 16 en regard du circuit 30 et des plots 4, au moyen d'une plaque épaisse 17 (voir figure 2), qui présente à la fois des propriétés élastiques, et des propriétés diélectriques appropriées au domaine des hyperfréquences, c'est-à-dire une faible permittivité et de faibles pertes. Un matériau avantageux pour constituer la plaque 17 est, par exemple, le caoutchouc naturel, ou encore un élastomère.

La pression apte à établir le contact électrique entre ces éléments est appliquée par l'intermédiaire d'un premier poussoir 8 d'un matériau isolant rigide, placée sur l'autre face de la plaque 17, et d'un second poussoir 7 également en un matériau isolant rigide appuyant sur la face 22 du boîtier. La pression est finement ajustée au moyen de la vis 6 agissant sur la seconde face de la plaque rigide 8.

Il reste alors à raccorder les extrémités 60 et 110 dites sorties du circuit 30 de la plaque 10 aux lignes hyperfréquences 205 qui alimentent les appareils de mesure. Ce raccordement est fait en portant le premier sous-ensemble (représenté figure 2) muni de la plaque rigide 10 et du boîtier sans broches 1 dans le deuxième sous-ensemble du dispositif de test, dont la totalité est représentée en coupe figure 5.

Ce second sous-ensemble est d'abord formé d'un socle 201, qui sert de guide au poussoir 8 et à la plaque 17, et dans lequel la vis 6 d'ajustage de la pression est vissée. Ce socle 201 peut être en un matériau isolant rigide, qui peut être du Plexiglass (marque déposée) par exemple.

Il comprend ensuite un capot à baïonnette 202, qui peut être du même matériau que le socle 201.

C'est dans ce capot 202 que se trouve centré le poussoir 7 dont la pression est appliquée sur le boîtier 1 par l'intermédiaire du ressort 209 et de la vis de réglage de pression 203.

Ce second sous-ensemble comprend encore un corps métallique 220, percé de part en part en son centre d'une ouverture munie d'un décrochement 219. Le premier sous-ensemble monté autour du boîtier 1 et de la plaque rigide 10 est placé dans cette ouverture de manière à ce que la face avant 12 de la plaque rigide 10 appuie sur le décrochement du corps métallique.

Ce corps métallique 220 est en outre percé sur sa périphérie de n ouvertures circulaires 218 dont les centres sont dans le même plan et dont le diamètre est approprié à ce que ces ouvertures servent de logement à des connecteurs 205 de lignes hyperfréquences coaxiales classiques. Ces ouvertures 218 sont distribuées à la périphérie du socle métallique selon une géométrie telle que leur centre coïncide avec les conducteurs centraux des lignes coplanaires comme, il est montré en coupe perpendiculairement à une ligne coaxiale sur la figure 6. Ainsi lorsque le premier sous-ensemble est en place dans l'ouverture centrale du corps, les conducteurs centraux 211 des lignes coaxiales 205 prennent appui sur les extrémités 60 des conducteurs centraux des lignes coplanaires, alors que les aires de masses 100 de ces dernières prennent appui sur le décrochement 219 du corps métallique qui constitue la masse du dispositif.

Le corps métallique 220 peut être par exemple en laiton ou bien en bronze doré.

Un presseur métallique 222, solidaire du corps métallique 220 par la série de vis 221, assure la pression de la face avant 12 de la plaque rigide 10 sur le décrochement 219 par l'intermédiaire d'un joint souple isolant 230. Cette pression permet d'obtenir un bon contact électrique entre les conducteurs centraux 211 et 60, et un couplage minimal entre les lignes hyperfréquences. En effet si la pression entre les aires de masse 100 et le décrochement 219 du corps métallique n'était pas suffisant, alors le couplage entre les lignes serait trop fort et les mesures seraient faussées.

Le dispositif selon l'invention permet d'obtenir un couplage minimal entre les lignes et une bonne continuité d'impédance.

La série des vis 204 permet de maintenir le socle 201 sur le corps métallique 220.

La série des vis 221 sert à la fois à fixer le presseur 222 sur le corps 220 et à constituer un ergot de fixation du capot 202 au corps 220.

Si la plaque diélectrique rigide 10 est circulaire, alors toutes les pièces du dispositif représenté figure 5 peuvent être de révolution autour de l'axe II', à l'exception du boîtier 1, de la plaque diélectrique élastique 17, de la plaque 8.

On notera encore que la plaque rigide 10, peut supporter, en sus du circuit de lignes coplanaires, des composants passifs pour aider les mesures, tels que résistances et condensateurs.

## Revendications

1. Dispositif de test pour boîtier sans broches (1), destiné à permettre le transport des signaux des n plots d'entrées/sorties (4, 5) de ce boîtier (1) vers des appareils de mesure, au moyen de lignes hyperfréquences d'impédance caractéristique donnée, dans le cas où ce boîtier (1) est muni d'une pastille (3) de circuit intégré hyperfréquences, caractérisé en ce qu'il comprend d'abord une plaque rigide (10), en un matériau présentant de bonnes qualités diélectriques en hyperfréquences, munie sur une face dite face avant d'un circuit imprimé (30) formant un réseau de n lignes hyperfréquences (50, 100) en technologie coplanaire, de l'impédance caractéristique donnée, divergentes de la région de la plaque (10) où est disposé le boîtier sans broche vers la périphérie de cette plaque (10), et en ce qu'il comprend en outre des premiers moyens (7, 8, 17, 16, 15) pour connecter les n plots du boîtier (1) aux n entrées des lignes du réseau coplanaire, et des seconds moyens (201, 202, 220, 222, 230) pour connecter les n sorties des lignes du réseau coplanaire aux lignes hyperfréquences coaxiales de même impédance donnée qui alimentent les appareils de mesure.

2. Dispositif de test selon la revendication 1, caractérisé en ce que la région (11) de la plaque (10), où est disposé le boîtier (1) est le centre de la plaque (10), et en ce que dans cette région la plaque rigide (10) présente une ouverture qui la traverse de part en part, et qui est de dimensions et de forme apte à laisser le passage sans frottements pour le boîtier (1), en ce que les n lignes coplanaires, qui sont réalisées sur la face avant de la plaque, sont disposées radialement à partir de cette ouverture, et en ce que le boîtier (1) est logé dans cette ouverture de manière telle que, les plots conducteurs (4, 5) du boîtier (1), situés sur la face dite face avant de ce dernier, sont placés d'une part dans le même plan que le circuit imprimé (30) de lignes coplanaires (50, 100), et d'autre part chacun en regard d'une extrémité (40, 90) dite entrée d'une ligne coplanaire.

3. Dispositif de test selon la revendication 2, caractérisé en ce que les premiers moyens sont constitués par :

a) une feuille de diélectrique (15) mince et souple portant, sur sa face dite avant, un circuit imprimé formant un réseau de n conducteurs (16) extrêmement courts conçu selon une géométrie appropriée à faire la connexion entre les entrées (40, 90) des lignes coplanaires et les plots correspondants (4, 5) du boîtier, la face avant de cette feuille (15) étant plaquée contre la face avant de la plaque rigide (10) et la face avant du boîtier (1) lorsque ce dernier est en place dans son logement (11), de manière telle que les conducteurs extrêmement courts de cette feuille viennent en cavaliers sur les entrées (40, 90) des lignes coplanaires et les plots correspondants (4, 5) du boîtier ;

b) une plaque diélectrique (17) épaisse et élastique faisant pression sur l'arrière de la feuille diélectrique mince ;

c) un premier système de poussoir (8) isolant et rigide maintenant la pression de la plaque (17) diélectrique épaisse et élastique sur la feuille (15) diélectrique mince ;

d) un second système de poussoir (7) isolant et rigide maintenant, par pression sur la face arrière du boîtier (1), le contact électrique entre les cavaliers (16), les entrées des lignes (40, 90) et les plots du boîtier (4, 5).

4. Dispositif de test selon la revendication 2 ou 3, caractérisé en ce que les seconds moyens sont constitués par :

a) un socle (201) isolant et rigide qui sert de guide à la plaque diélectrique (17) épaisse et élastique, et à son système de poussoir (8);

b) un capot à baïonnette (202) isolant et rigide qui maintient le système de poussoir (7) appliqué à l'arrière du boîtier (1);

c) un corps métallique (220) servant de masse électrique, percé en son centre d'une ouverture munie d'un décrochement (219) pour recevoir l'assemblage desdits premiers moyens, la face avant (12) de la plaque rigide (10) prenant appui sur le décrochement, et percé sur sa périphérie de n ouvertures circulaires (218) pour servir de logement à n connecteurs (205) de lignes coaxiales classiques, distribuées selon une géométrie appropriée à ce que chaque conducteur central (211) de ces lignes coaxiales (205) vienne en coïncidence avec une extrémité (60) de ligne coplanaire dite sortie, en sorte que du fait de ces n ouvertures seules les aires de masse (100) des lignes coplanaires prennent appui sur le corps métallique (219), alors que les conducteurs centraux (60) des lignes coplanaires prennent appui sur les conducteurs centraux (211) des lignes coaxiales (205);

d) un presseur métallique (222), solidaire du corps métallique (220) pour presser, par l'intermédiaire d'un joint souple (230) les sorties des conducteurs centraux (211) des lignes coplanaires (205) sur les conducteurs centraux (60) des lignes coaxiales, et les aires de masse (110) des lignes coplanaires sur le décrochement (219) du socle (220) formant masse électrique ;

e) une série de vis (221) pour maintenir le presseur (222) et le capot à baïonnette sur le corps métallique (220) d'une part, et une série de vis (204) pour maintenir le socle isolant (201) sur le corps métallique (220) d'autre part.

5. Dispositif de test selon l'une des revendications 1 à 4, caractérisé en ce que la plaque diélectrique rigide (10) est en céramique.

6. Dispositif de test selon l'une des revendications 1 à 5, caractérisé en ce que la plaque diélectrique rigide (10) est circulaire.

7. Dispositif de test selon la revendication 6 caractérisé en ce que toutes les pièces sont de révolution à l'exception de la plaque diélectrique élastique (17) et de son système de poussoir (8).

8. Dispositif de test selon l'une des revendications 1 à 7, caractérisé en ce que la plaque diélectrique rigide (10) porte également des composants passifs tels que résistances et capacités.

**Claims**

1. A testing apparatus for a leadless envelope (1) intended to permit the transport of signals from the n input/output contacts (4,5) of this envelope (1) to measuring apparatus by means of high-frequency lines having a given characteristic impedance in the case in which this envelope (1) is provided with a high-frequency integrated circuit chip (3), characterized in that it first comprises a rigid plate (10) of a material having favourable dielectric properties for high frequencies provided at a surface (designated as front surface) with a printed circuit (30) forming a network of n high-frequency lines (50,100) according to the coplanar technology having the given characteristic impedance, which lines diverge from the region of the plate (10) where the leadless envelope is arranged towards the periphery of this plate (10), and in that it moreover comprises first means (7,8,17,16,15) for connecting the n contacts of the envelope (1) to the n inputs of the lines of the coplanar network, and second means (201,202, 220,222,230) for connecting the n outputs of the lines of the coplanar network to the high-frequency coaxial lines having the same given impedance, which supply the measuring apparatus.

2. A testing apparatus as claimed in Claim 1, characterized in that the region (11) of the plate (10) where the envelope (1) is accommodated is the centre of the plate (10), in that the rigid plate (10) has in this region an opening which traverses it from one side to the other and has dimensions and a shape allowing for the passage without friction of the envelope (1), in that the n coplanar lines formed on the front surface of the plate are disposed radially from this opening, and in that the envelope (1) is accommodated in this opening in such a manner that the conducting contacts (4,5) of the envelope (1) situated on the said front surface of the latter are arranged on the one hand in the same plane as the printed circuit (30) of coplanar lines (50,100) and on the other hand each opposite to an end (40,90) designated as input of a coplanar line.

3. A testing apparatus as claimed in Claim 2, characterized in that the first means are constituted by:

   a) a plate of a thin and flexible dielectric (15) carrying at its front surface a printed circuit forming a network of n extremely short conductors (16) designed according to a geometry suitable to establish the connection between the inputs (40,90) of the coplanar lines and the corresponding contacts (4,5) of the envelope, the front surface of this plate (15) being placed against the front surface of the rigid plate (10) and the front surface of the envelope (1) when the latter is positioned in its recess (11) in such a manner that the extremely short conductors of this plate are located as tabs on the inputs (40,90) of the coplanar lines and the corresponding contacts (4,5) of the envelope;
   b) a thick and elastic dielectric plate (17) exerting a pressure on the back of the thin dielectric plate;
   c) a first insulating and rigid pressure system (8) maintaining the pressure of the thick and elastic dielectric plate (17) on the thin dielectric plate (15);
   d) a second insulating and rigid pressure system (7) maintaining by pressure on the back surface of the envelope (1) the electric contact between the tabs (16), the inputs of the lines (40,90) and the contacts (4,5) of the envelope.

4. A testing apparatus as claimed in Claim 2 or 3, characterized in that the second means are constituted by:

   a) an insulating and rigid base (201) serving as a guide for the thick and elastic dielectric plate (17) and for its pressure system (8);
   b) an insulating and rigid bayonet cap (202) holding the pressure system (7) in a position in which it bears on the back of the envelope (1);
   c) a metal body (220) serving as electrical mass, provided in its centre with an opening having a shoulder (219) for receiving the assembly of the said first means, the front surface (12) of the rigid plate (10) bearing on the shoulder, and provided along its periphery with n circular openings (218) serving as recesses for n connectors (205) of conventional coaxial lines distributed according to a geometry suitable to ensure that each central conductor (211) of these coaxial lines (205) coincides with an end (60) of a coplanar output line in such a manner that due to these n openings only the mass regions (100) of the coplanar lines bear on the metal body (219), while the central conductors (60) of the coplanar lines bear on the central conductors (211) of the coaxial lines (205);

d) a metal pressure member (222) integral with the metal body (220) for pressing by means of a flexible joint (230) the outputs of the central conductors (211) of the coplanar lines (205) on the central conductors (60) of the coaxial lines, and the mass regions (110) of the coplanar lines on the shoulder (219) of the base (220) forming the electrical mass;

e) a series of screws (221) for holding the pressure member (222) and the bayonet cap on the metal body (220) on the one hand, and a series of screws (204) for holding the insulating base (201) on the metal body (220) on the other hand.

5. A testing apparatus as claimed in any one of Claims 1 to 4, characterized in that the rigid dielectric plate (10) is made of ceramic material.

6. A testing apparatus as claimed in any one of Claims 1 to 5, characterized in that the rigid dielectric plate (10) is circular.

7. A testing apparatus as claimed in Claim 6, characterized in that all the parts are bodies of revolution except for the dielectric elastic plate (17) and its pressure system (8).

8. A testing apparatus as claimed in any one of Claims 1 to 7, characterized in that the rigid dielectric plate (10) also carries passive components, such as resistors and capacitors.

## Ansprüche

1. Testanordnung für einen Träger ohne Anschlußdrähte (1) zum Transportieren von Signalen der n Eingangs-/Ausgangskontaktsätze (4,5) dieses Trägers (1) über HF-Leitungen einer bestimmten charakteristischen Impedanz zu Meßanordnungen, in dem Fall, wo dieser Träger (1) mit einem HF-IC-Chip (3) versehen ist **dadurch gekennzeichnet**, daß die Testanordnung zunächst eine starre Platte (10) aufweist aus einem Werkstoff, der gute dielektrische Eigenschaften bei hohen Frequenzen aufweist, wobei diese Platte auf einer als Vorderfläche bezeichneten Fläche einer gedruckten Schaltung (30) angebracht ist, die ein Netzwerk von n HF-Leitungen (50, 100) vom koplanaren Typ mit einer bestimmten charakteristischen Impedanz bildet, divergierend von dem Gebiet der Platte (10), an dem der Träger ohne Anschlußdrähte angebracht ist, zu dem Rand dieser Platte (10), und daß sie außerdem erste Mittel (7, 8, 17, 16, 15) aufweist zum Verbinden der n Kontaktsätze (1) mit den n Eingängen der Leitungen des koplanaren Netzwerkes, und zweite Mittel (201, 202, 220, 222, 230) zum Verbinden der n Ausgänge der Leitung des koplanaren Netzwerkes mit den koaxialen HF-Leitungen derselben bestimmten Impedanz, welche die Meßgeräte Speisen.

2. Testanordnung nach Anspruch 1, **dadurch gekennzeichnet,** daß das Gebiet (11) der Platte (10), an dem der Träger (1) angeordnet ist, die Mitte der Platte (10) ist und daß in diesem Gebiet die starre Platte (10) eine Öffnung bildet, die das Gebiet teilweise durchquert, und die derart bemessen und von derartiger Form ist, daß der Träger (1) reibungslos hindurchgehen kann, daß die n koplanaren Leitungen, die auf der Vorderfläche der Platte vorgesehen sind, radial angebracht sind, ausgehend von dieser Öffnung, und daß der Träger (1) derart in dieser Öffnung liegt, daß die Kontaktstellen (4,5) des Trägers (1), die auf der als Vorderfläche bezeichneten Fläche desselben vorgesehen sind, einerseits in derselben Ebene liegen wie die gedruckte Schaltung (30) der koplanaren Leitungen (50, 100) und andererseits je gegenüber einem als Eingang bezeichneten Ende (40, 90) einer koplanaren Leitung.

3. Testanordnung nach Anspruch 2, **dadurch gekennzeichnet,** daß die ersten Mittel aus den folgenden Elementen gebildet werden:

a) einer dünnen, geschmeidigen dielektrischen Folie (15), auf deren als Vorderfläche bezeichneten Fläche eine gedruckte Schaltung vorgesehen ist, die ein Netzwerk aus n äußerst kurzen Leitern (16) bildet, angebracht entsprechend einer Geometrie, die sich dazu eignet, die Eingänge (40, 50) der koplanaren Leitungen mit den entsprechenden Kontaktflächen (4, 5) des Trägers zu verbinden, wobei die Vorderfläche dieser Folie (15) an der Vorderfläche der starren Platte (10) und der Vorderfläche des Trägers (1) festgeklebt ist, während letzterer sich an seinem Platz (11) befindet, derart, daß die äußerst kurzen Leitungen dieser Folie U-förmig um die Eingänge (40, 90) der koplanaren Leitungen und der entsprechenden Stellen (4,5) des Trägers gelangen;

b) einer dünnen und elastischen dielektrischen Platte (17), die auf die Rückseite der dünnen dielektrischen Folie Druck ausübt;

c) einem ersten isolierende und starren Drucksystem (8), das den Druck der dünnen, elastischen dielektrischen Platte (17) auf die dünne dielektrische Folie (15) beibehält;

d) einem zweiten isolierenden und starren Drucksystem (7), das durch Druckausübung auf die Rückseite des Trägers (1) den elektrischen Kontakt zwischen den Kontaktbrücken (16), den Eingängen der Leitungen (40, 90) und den Kontaktflächen des Trägers (4,5) beibehält.

4. Testanordnung nach Anspruch 2 oder 3, **dadurch gekennzeichnet**, daß die zweiten Mittel aus den folgenden Elementen gebildet werden:

a) einem isolierenden und starren Sockel (201), der zum Führen der dünnen und elastischen dielektrischen Platte (17) und des Drucksystems (8) derselben dient;

b) einer isolierenden und starren Bajonettkappe (202), die das Drucksystem (7) auf der Rückseite des Trägers (1) beibehält;

c) einem Metallkörper (220), der als elektrische Masse dient, der in der Mitte mit einer Öffnung versehen ist, die eine Schulter (219) aufweist zum Enthalten des Gefüges aus den ersten Mitteln, wobei die Vorderfläche (12) der starren Platte (10) an der Schulter anliegt, und der am Umfang mit n kreisförmigen Öffnungen (218) versehen ist zum Unterbringen von n Verbindungselementen (205) für herkömmliche Koaxialleitungen, wobei diese Öffnungen entsprechend einer geeigneten Geometrie verteilt derart verteilt sind, daß jeder zentrale Leiter (211) dieser Koaxialleitungen (205) mit einem Ende (60) der als Ausgang bezeichneten koplanaren Leitung zusammentrifft, so daß deshalb von den n Öffnungen nur die Massengebiete (100) der koplanaren Leitungen auf dem Metallkörper (219) aufliegen, während die zentralen Leiter (60) der koplanaren Leitungen auf den zentralen Leitern (211) der Koaxialleitungen (205) aufliegen;

d) einem metallischen Druckelement (222), das mit dem Metallkörper (220) einen Teil bildet, um mittels einer geschmeidigen Verbindung (230) die Ausläufer der zentralen Leiter (211) der koplanaren Leitungen (205) auf die zentralen Leiter (60) der Koaxialleitungen zu drücken, und um die Massengebiete (110) der koplanaren Leitungen auf die Schulter (219) des elektrische Masse bildenden Sockels (220) zu drücken;

e) einerseits einer Reihe von Schrauben (221) um das Druckelement (222) und die Bajonettkappe auf dem Metallkörper (220) zu halten und andererseits einer Reihe von Schrauben (204) um den isolierenden Sockel (201) auf dem Metallkörper (220) zu halten.

5. Testanordnung nach einem der Ansprüche, 1 bis 4, **dadurch gekennzeichnet**, daß die starre dielektrische Platte (10) aus Keramik besteht.

6. Testanordnung nach einem der Ansprüche 1 bis 5, **dadurch gekennzeichnet**, daß die starre dielektrische Platte (10) kreisförmig ist.

7. Testanordnung nach Anspruch 6, **dadurch gekennzeichnet**, daß alle Teile Umdrehungskörper sind, ausgenommen die elastische dielektrische Platte (17) und deren Drucksystem (8).

8. Testanordnung nach einem der Ansprüche 1 bis 7, **dadurch gekennzeichnet**, daß die starre dielektrische Platte (10) ebenfalls passive Schaltungselemente, wie Widerstände und Kapazitäten, aufweist.

FIG.1a

FIG.1b

FIG.1c

FIG.2

FIG.4

FIG. 3

**FIG.5**

**FIG.6**